# EUROPEAN PATENT SPECIFICATION

(11) **EP 1 626 585 B1**
(45) Date of publication and mention of the grant of the patent: **02.07.2008**
(21) Application number: 05107052.2
(22) Date of filing: 29.07.2005
(51) Int. Cl.: H04N 9/31, G02F 1/13357, G02B 27/14, G03B 21/20

(54) **Illumination unit for an image projecting apparatus**
Beleuchtungseinheit für eine Bildprojektionsvorrichtung
Unité d'éclairage pour un dispositif de projection d'image

(30) Priority: 03.08.2004 KR 2004061095
(43) Date of publication of application: 15.02.2006
(73) Proprietor: Samsung Electronics Co., Ltd, Suwon-si, Gyeonggi-do 442-742 (KR)
(72) Inventor: Lee, Kye-hoon, Suwon-si Gyeonggi-do (KR); Lee, Won-yong, Yeongtong-gu, Suwon-si Gyeonggi-do (KR); Lee, Young-chol, Gyeonggi-do, (KR); Sokolov, Kirill, Suwon-si Gyeonggi-do (KR)
(74) Representative: Read, Matthew Charles

(56) References cited:
- WO-A-20/04109366
- US-A1- 2002 003 609
- US-A1- 2002 181 117
- PATENT ABSTRACTS OF JAPAN vol. 2003, no. 12, 5 December 2003 (2003-12-05) -& JP 2004 070018 A (MITSUBISHI ELECTRIC CORP), 4 March 2004 (2004-03-04)
- PATENT ABSTRACTS OF JAPAN vol. 2003, no. 12, 5 December 2003 (2003-12-05) -& JP 2004 070017 A (MITSUBISHI ELECTRIC CORP), 4 March 2004 (2004-03-04)
- PATENT ABSTRACTS OF JAPAN vol. 012, no. 254 (E-634), 16 July 1988 (1988-07-16) -& JP 63 039294 A (CANON INC), 19 February 1988 (1988-02-19)

## Description

The invention relates to an illumination unit arranged to synthesise light beams emitted by a compact light source and an image projecting apparatus comprising such an illumination unit.

Generally, illumination units include a light source emitting light beams in a predetermined direction and an optical system through which the light beams are transmitted. Such illumination units are widely used in image projecting apparatuses that generate an image using a non-emissive image forming device, such as an LCD device or a digital micromirror device (DMD).

Illumination units that utilise a compact light emitting device, such as a light emitting diode (LED) or a laser diode, as a light source have been developed. A compact light emitting device which can generate red, blue, and green light beams is advantageous as it does not require an additional colour wheel mechanism generate light of a given colour for the display of a colour image by a panel type projecting apparatus. In order to generate red, green and blue light, a plurality of compact light emitting devices is required, together with a mechanism for combining their output.

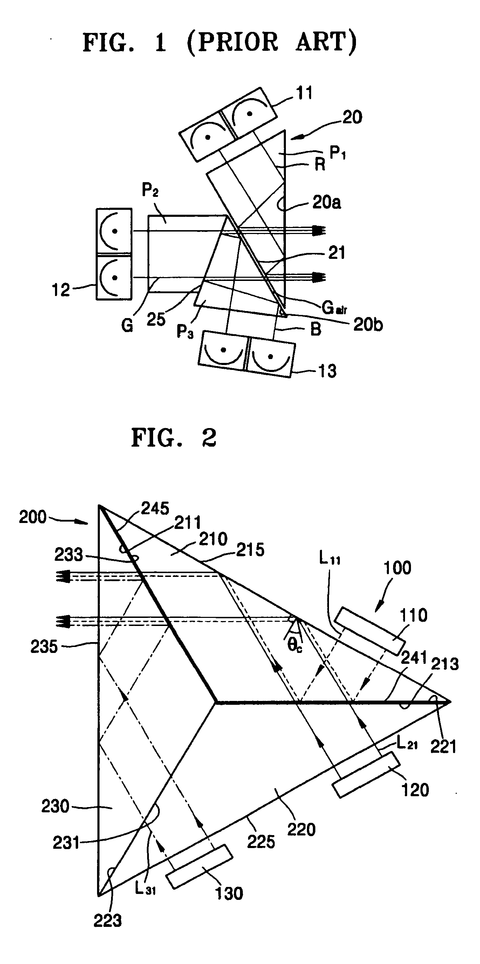

Referring to Figure 1, a known illumination unit that emits red, blue and green light beams includes first, second and third LED light sources 11, 12, and 13, arranged at different positions, and a trichroic prism 20 which causes light emitted by the first, second and third LED light sources 11, 12, and 13 to propagate along a common optical path.

The trichroic prism 20 includes first, second and third prisms P₁, P₂, and P₃, which are individual prisms combined together, a first colour filter 21 provided between the first prism P₁ and the third prism P₃ and a second colour filter 25 provided between the second prism P₂ and the third prism P₃. The first and second colour filters 21 and 25 selectively transmit or reflect incident light beams depending on their wavelength. For example, the first colour filter 21 reflects a first light beam R having a red wavelength and transmits second and third light beams G and B having green and blue wavelengths, respectively. The second colour filter 25 reflects the third light beam B and transmits the second light beam G.

The first light beam R, when incident on the first prism P₁, undergoes total internal reflection at an exit surface 20a of the first prism P1 and then travels toward the first colour filter 21. The first light beam R is then reflected by the first colour filter 21 and passes through the exit surface 20a of the first prism P₁ to travel along a given optical path. The second light beam G sequentially passes through the second and first colour filters 25 and 21 and proceeds along the same optical path as the first light beam R. The third light beam B undergoes total internal reflection at a surface 20b of the third prism P₃ that faces the first prism P₁ and is reflected by the second colour filter 25 before passing through the third and first prisms P₃ and P₁ and proceeding along the same optical path as the first and second light beams R and G. In this manner, the first, second and third light beams R, G, and B emitted by the first, second and third LED light sources 11, 12, and 13 respectively are combined, so that they propagate along a common optical path.

In order to ensure that the third light beam B is totally reflected by the surface 20b of the third prism P₃, the first prism P₁ and the third prism P₃ must be separated by a predetermined gap Gₐᵢᵣ. This is because the achievement of total internal reflection depends on the angle between the surface 20b of the third prism P₃ and the third light beam B, and on the difference between the refractive index of the third prism P₃ and the refractive index of the surrounding medium. Therefore, this type of arrangement has a drawback in that the trichroic prism 20 must be configured precisely.

Furthermore, it may be difficult to install an additional light source, for example, a source of yellow, magenta, or cyan light, in addition to the first through third light sources, due to limitations in the optical arrangement of the trichroic prism 20. Thus, the range of colour that can be realised by the arrangement of Figure 1 may be more limited than that obtainable from an illuminating unit using a four colour light source.

US 2002/003609 A1 and US 2002/181117 A1 disclose imaging apparatuses comprising colour separation and recombination means in the form of three triangular prisms, arranged to form an equilateral triangle. Dichroic filters are placed between two of the three interfaces between the prisms. White light is input through an outer surface of one of the prisms and split into three components.
Each component is directed to a corresponding light modulating means at outer surfaces of the prisms, reflected back into the prism arrangement and recombined.

Prior illumination units arranged to combine light from more than three light sources are disclosed in JP2004-70017A, which discloses two separate prism arrangements, similar to that shown in Figure 1, that each combine light from three light sources, and JP2004-70018A, which discloses an arrangement for combining light four light sources using five triangular prisms.

One object of the present invention is the provision of an illumination unit with improved light combining means, to combine light beams emitted by compact light sources, and an image projecting apparatus employing the same.

According to the invention, an illumination unit comprises a plurality of light source units, comprising first, second, third and fourth light source units arranged to emit light beams in first, second, third and fourth wavelength ranges respectively, said first, second and third wavelength ranges being different from one another; and a synthesizing prism arranged to combine the light beams emitted from the light source units, comprising a first triangular prism comprising a first outer surface configured to transmit or reflect light according to a direction from which the light beams is incident, and first and second boundary surfaces, a second triangular prism comprising a second outer surface configured to transmit light, a third boundary surface arranged to face the second boundary surface, and a fourth boundary surface, a third triangular prism comprising a third outer surface configured to transmit or reflect light according to a direction from which the light is incident, a fifth boundary surface arranged to face the fourth boundary surface, and a sixth boundary surface arranged to face the first boundary surface, and a first dichroic filter arranged between the second boundary surface and the third boundary surface to reflect light in the first wavelength range and to transmit light in the second wavelength range, a second dichroic filter arranged between the sixth boundary surface and the first boundary surface, configured to reflect the light in the third and fourth wavelength ranges and to transmit light in the first and second wavelength ranges and a third dichroic filter arranged between the fourth boundary surface and the fifth boundary surface, configured to reflect light beam in the fourth wavelength range and to transmit light in the third wavelength range.

This arrangement can be set up relatively straightforwardly when compared with the prior art arrangement shown in Figure 1.

The first, second, and third triangular prisms may have the same shape and size. The first, second and third triangular prisms may be congruent isosceles triangles, arranged to form an equilateral triangle.

This aspect also provides an image projection apparatus comprising such an illumination unit, together with an imaging device, such as a LCD panel or DMD, wherein the illumination unit is arranged to provide illumination for the imaging device.

Embodiments of the invention will now be described with reference to the accompanying drawings, of which:
Figure 1 depicts an optical arrangement of a conventional illumination unit;
Figure 2 depicts an optical arrangement of an illumination unit outside the scope of the invention;
Figure 3 is a perspective view of a light source unit of the illumination unit of Figure 2;
Figure 4 is a side view of the light source unit of the illumination unit of Figure. 2;
Figure 5 is a perspective view of an alternative light source unit for use in the illumination unit of Figure 2;
Figure 6 depicts an optical arrangement of another illumination unit outside the scope of the invention;
Figure 7 depicts an optical arrangement of an illumination unit according to a first embodiment of the invention;
Figure 8 depicts an optical arrangement of an illumination unit according to a second embodiment of the invention;
Figure 9 depicts an optical arrangement of an image projecting apparatus outside the scope of the present invention;
Figure 10 depicts another optical arrangement of another image projecting apparatus outside the scope of the present invention; and
Figure 11 depicts an optical arrangement of yet another image projecting apparatus outside the scope of the present invention.

In the accompanying drawings, like reference numerals refer to the like elements throughout.

In order to assist in the detailed description of example embodiments, two arrangements outside the scope of the present invention will now be discussed.

Referring to Figure 2, an illumination unit outside the scope of the invention includes a plurality of light source units 100. The light source units 100 are configured to emit light of different wavelengths from one another. A synthesising prism arrangement 200 is provided to combine incident light beams so that the light emitted from the light source units 100 propagates along a common optical path.

The plurality of light source units 100 includes first, second, and third light source units 110, 120, and 130 arranged at different positions. The first, second, and third light source units 110, 120, and 130 emit first, second and third light beams L₁₁, L₂₁, and L₃₁ having different wavelengths. In this particular example, the first, second and third light beams L₁₁, L₂₁, and L₃₁ are of green, blue, and red light respectively.

The prism arrangement 200 has a triangular column shape and includes first, second, and third triangular prisms 210, 220, and 230. Each triangular prism 210, 220, 230 has an outer surface, which transmits or totally reflects a light beam depending on its angle of incidence, and two boundary surfaces that are coupled to the other two triangular prisms. A colour separation portion is provided at at least one boundary between the first, second, and third triangular prisms 210, 220, and 230 to selectively transmit and reflect incident light, depending on its wavelength.

The first triangular prism 210 has first and second boundary surfaces 211 and 213 and a first outer surface 215 that transmits or reflects incident light according to its angle of incidence.

The first light source unit 110 is arranged to face the first outer surface 215, while a second light source unit 120 is arranged to face a second outer surface 225. The first light beam L₁₁ emitted from the first light source unit 110 is transmitted through the first outer surface 215 and proceeds toward the second boundary surface 213, from which they are reflected. As shown in Figure 2, the incident angles of the first light beam L₁₁, following its reflection from the second boundary surface 213, and a second light beam L₂₁ on the first outer surface 215 exceeds a critical angle θc. Thus, the first and second light beams L₁₁, L₂₁ undergo total internal reflection at the first outer surface 215 and proceed toward the first boundary surface 211. Then, the first and second light beams L₁₁ and L₂₁ are transmitted through a third outer surface 235 of the third triangular prism 130, which is described later, and proceed along a common optical path.

Total internal reflection occurs at the first boundary surface 215 if the refractive index of the first triangular prism 210 is greater than the refractive index of a surrounding medium and the first and second light beams L₁₁ and L₂₁ are incident at an angle greater than the critical angle θc inside the first triangular prism 210.

The second triangular prism 220 has third and fourth boundary surfaces 221 and 223 and the second outer surface 225, which is configured to transmit incident light.

The third boundary surface 221 is arranged to face the second boundary surface 213 of the first triangular prism 210.

Like the second light source unit 120, the third light source unit is arranged to face the second outer surface 225. The second light beam L₂₁ emitted from the second light source unit 120 is transmitted through the second outer surface 225 to proceed toward the third boundary surface 221 while the third light beam L₃₁ emitted from the third light source unit 130 is transmitted through the second outer surface 225 and proceeds toward the fourth boundary surface 223.

The third triangular prism 230 has fifth and sixth boundary surfaces 231 and 233 and the third outer surface 235 configured to transmit or reflect an incident light beam, depending on its angle of incidence. The fifth boundary surface 231 is arranged to face the fourth boundary surface 223 of the second triangular prism 220 while the sixth boundary surface 233 is arranged to face the first boundary surface 211 of the first triangular prism 210. The third light beam L₃₁ emitted from the third light source unit 130, undergoes total internal reflection at the third outer surface 235 and proceeds toward the sixth boundary surface 233. The third light beam L₃₁ then undergoes total internal reflection at the sixth boundary surface 233. The first, second, and third light beams L₁₁, L₂₁, and L₃₁ passing through or, in the case of the third light beam L₃₁, reflected by the sixth boundary surface 233, are transmitted through the third outer surface 235 and propagate along the common optical path.

The first, second, and third triangular prisms 210, 220, and 230 have the same shape and size so that the first, second, and third light beams L₁₁, L₂₁, and L₃₁ input from different positions emerge from the prism arrangement 200 to propagate along the common optical path. In this particular example, the first triangular prism 210 has the shape of an isosceles triangle in which an angle between the first boundary surface 211 and the second boundary surface 213 is 120°, while an angle between the first boundary surface 211 and the first outer surface 215 and an angle between the second boundary surface 213 and the first outer surface 215 are each 30°. Likewise, the second and third triangular prisms 220 and 230 also have the shape of an isosceles triangle with the same dimensions as the first triangular prism 210. However, in an alternative arrangement, the second and third triangular prisms 220 and 230 may instead be formed in a single monolithic body which does not have the fourth and fifth boundary surfaces 223 and 231.

The colour separation portion is arranged at at least one of positions between the second boundary surface 213 and the third boundary surface 221, the fourth boundary surface 223 and the fifth boundary surface 231, and the sixth boundary surface 233 and the first boundary surface 211. In the arrangement of Figure 2, the colour separation portion includes first and second dichroic filters 241 and 245 provided between the second boundary surface 213 and the third boundary surface 221, and the sixth boundary surface 233 and the first boundary surface 211, respectively.

The first dichroic filter 241 reflects the first light beam L₁₁, as it is in a first wavelength range, and transmits the second light beam L₂₁, as it is in a second wavelength range. In this example, the first dichroic filter 241 is configured to reflect light having a wavelength greater than a predetermined threshold and transmit light having a wavelength that is lower than the predetermined threshold. For example, if the predetermined threshold were 500 nm, green light would be reflected as its wavelength is longer than 500 nm, while blue light, having a wavelength shorter than 500 nm, would be transmitted. Thus, when the first light beam L₁₁ is a light beam in a green wavelength range and the second light beam L₂₁ is a light beam in a blue wavelength range, the first dichroic filter 214 reflects the first light beam L₁₁ and transmits the second light beam L₂₁.

The second dichroic filter 245 reflects the third light beam L₃₁ in a third wavelength range, for example, a red wavelength range, and transmits the first and second light beams L₁₁ and L₂₁ in other wavelength ranges. Here, the predetermined threshold is a wavelength between the red and green wavebands, for example, a 565 nm wavelength. Thus, when the first and second light beams L₁₁ and L₂₁ are light beams in the green and blue wavelength ranges and the third light beam L₃₁ is a light beam in the red wavelength range, the first and second light beams L₁₁ and L₂₁ are transmitted by the second dichroic filter 245, as their wavelength is shorter than the predetermined threshold, while the third light beam L₃₁ is reflected.

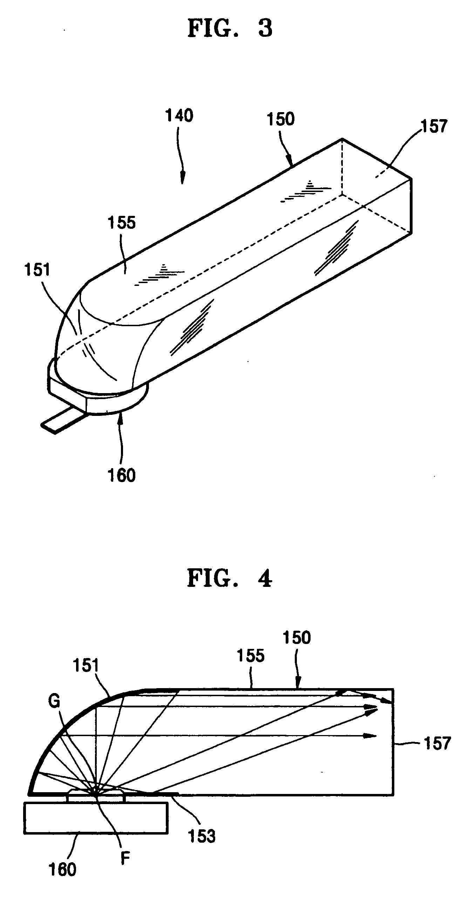

Each of the first, second, and third light source units 110, 120, and 130 comprises at least one optical module 140, as illustrated in Figures 3, 4 and 5.

Referring to Figures 3, 4 and 5, an optical module 140 includes a light source 160, arranged to emit light of a predetermined wavelength, and a collimator 150. The light source 160 is a compact light source having at least one light emitting diode (LED) or a laser diode. The collimator 150 includes a first reflection surface 151 and a glass rod 155 having a rectangular section. A light emitting portion of the light source 160 is located on and around a focus F of the first reflection surface 151 of the collimator 150. The first reflection surface 151 is provided by forming part of the glass rod 155 into a parabolic surface and reflection-coating an outside portion of the parabolic surface. The collimator 150 can be provided with a second reflection surface 153 formed at a portion of the collimator 150 facing the first reflection surface 151. The second reflection surface 153 is formed by coating the relevant portion of the collimator 150 with a reflective material, leaving an area G, through which the light by the light source 160 passes, clear.

A light beam within a predetermined radiation angle range of the light emitted by the light source 160 is reflected by the first reflection surface 151 and forms a parallel beam. The parallel beam passes through the glass rod 155 and leaves the collimator 150 via an exit surface 157. Since the light emitting portion of the light source 160 does not form a point but has a predetermined area, it is not possible for the entirety of the light emitting portion to be located at the focus F. Thus, a portion of the light emitted from the light source 160 is reflected by the first reflection surface 151 towards the second reflection surface 153. The second reflection surface 153 reflects the incident light so that it proceeds toward the exit surface 157. Here, each exit surface 157 may be arranged to face a corresponding one of the first, second, and third outer surfaces 215, 225, and 235 of the prism arrangement 200.

Since the optical module 140 collimates the light emitted by the light source 160 using the first reflection surface 151 instead of a lens, low efficiency problems arising from principle limitations, such as etendue, which may occur when a lens is used, can be avoided.

Although the collimator 150 described above comprises a glass rod 155, it is possible to provide the parabolic surface within an optical tunnel (not shown) comprising a hollow rod, instead of the glass rod 155. In this case, the reflection surface may be provided by reflection-processing the inside of the optical tunnel.

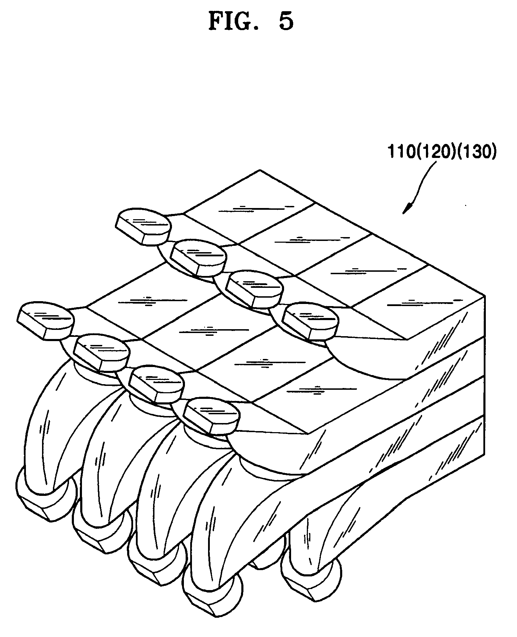

In the illumination unit of Figure 2, each of the first, second, and third light source units 110, 120, and 130 may be formed of a plurality of the optical modules 140 arranged in an array, as illustrated in Figure 5. In this case, each of the optical modules 140 forming each of the first, second, and third light source units 110, 120, and 130 emits light in the red, green, or blue waveband. Thus, by simultaneously or sequentially driving the first, second, and third light source units 110, 120, and 130, a full colour light beam formed by a combination of these light beams can be emitted. Furthermore, when the illumination unit is used in an image projecting apparatus, to be described later, a colour light beam can be provided without requiring the use of a colour wheel mechanism.

Since the light emitted by the first, second, and third light source units 110, 120, and 130 is combined by the prism arrangement 200, which has a triangle prism structure, an optical path can be changed easily, according to the critical angle total internal reflection principle, and the optical arrangement is straightforward when compared with a conventional trichroic prism structure.

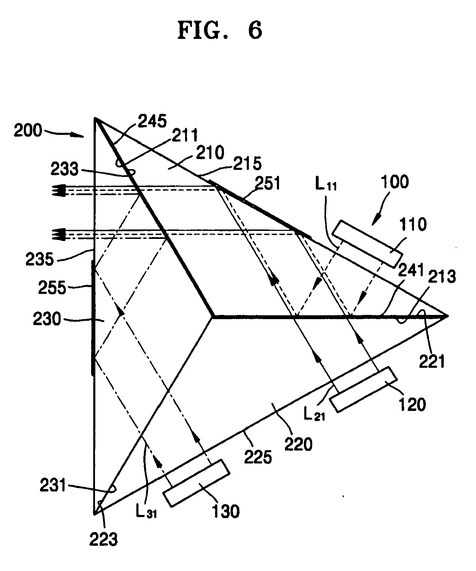

Figure 6 is a view of an optical arrangement of an illumination unit according to a second arrangement outside the scope of the invention. The illumination unit includes a plurality of the light source units 100 to emit light beams having different wavelengths and the prism arrangement 200 arranged to combine incident light beams so that each of the light beams emitted from the light source units 100 propagate along a common path.

The prism arrangement 200 of Figure 6 differs from that of Figure 2 in that it does not use total internal reflection to direct the light emitted by the light source units 100. Instead, first and second reflection layers 251, 255 are provided on the first and third outer surfaces 215, 235 respectively. However, since the configuration and arrangement of other constituent elements except for the above layers 251 and 255 are substantially the same as those of the illumination unit of Figure 2, detailed descriptions thereof will be omitted.

The first reflection layer 251 is provided by coating a portion of the first outer surface 215 with a reflective material, so that the first and second light beams L₁₁ and L₂₁ are reflected when passing through the first dichroic filter 241. Since the first reflection layer 251 does not extend over a portion of the first outer surface 215, it does not impede the first light beam L₁₁ when entering the first dichroic filter 241.

The second reflection layer 255 is formed by coating a portion of the third outer surface 235 with a reflective material to reflect the third light beam L₃₁ emitted by the third light source unit 130. Since the second reflection layer 255 does not obstruct the optical path along which the first, second, and third light beams L₁₁, L₂₁, and L₃₁ exit the second dichroic filter 245, it does not impede the propagation of the first, second, and third light beams L₁₁, L₂₁, and L₃₁ through the third outer surface 235 when leaving the second dichroic filter 245.

The use of first and second reflection layers 251 and 255 means that light beams can be reflected, regardless of whether their angle of incidence is greater than the critical angle θc.

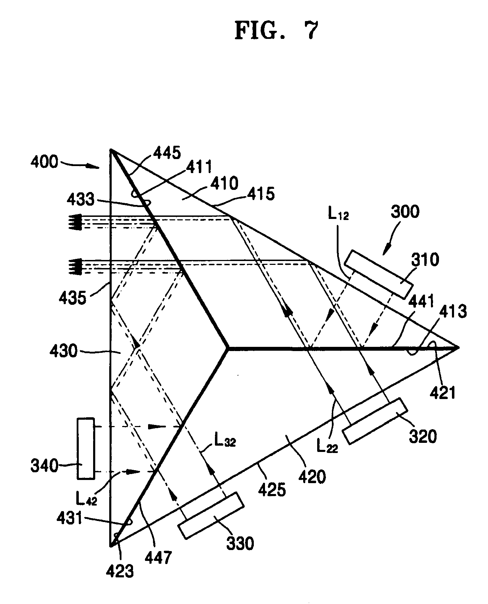

Figure 7 depicts an optical arrangement of an illumination unit according to a first embodiment of the invention. Here, the illumination unit includes a plurality of light source units 300 to emit light at different wavelengths and a prism arrangement 400 configured to combine incident light beams so that light emitted by the light source units 300 propagates along a common path.

The light source units 300 include first, second, third, and fourth light source units 310, 320, 330, and 340 arranged at different positions. The first, second, third, and fourth light source units 310, 320, 330, and 340 emit first, second, third, and fourth light beams L₁₂, L₂₂, L₃₂, and L₄₂ having different wavelengths, for example, light beams having green, blue, red, and yellow wavelengths, respectively. Since the configuration of each of the first, second, third, and fourth light source units 310, 320, 330, and 340 is the same as those described with reference to Figures 3, 4 and 5, detailed descriptions thereof are omitted.

The prism arrangement 400 is shaped as a triangular column and includes first, second, and third triangular prisms 410, 420, and 430. Each prism 410, 420, 430 has an outer surface 415, 425, 435 to transmit or reflect a light beam depending on its angle of incidence, and boundary surfaces coupled to the other two triangular prisms. A colour separation portion is provided at at least one of the boundaries between the first, second, and third triangular prisms 410, 420, and 430 to selectively transmit or reflect incident light depending on its wavelength.

The first triangular prism 410 includes first and second boundary surfaces 411 and 413 and first outer surface 415 which transmits or reflects incident light according to its wavelength. The second triangular prism 420 includes third and fourth boundary surfaces 421 and 423 and a second outer surface 425 which transmits incident light. The third triangular prism 430 includes fifth and sixth boundary surfaces 431 and 433 and a third outer surface 435 which transmits or reflects an incident light beam depending on its wavelength. The arrangement of each of the first, second, and third triangular prisms 410, 420, and 430 and the arrangement of the first, second, and third light source units 310, 320, and 330 are substantially the same as the arrangement of the first, second, and third triangular prisms 210, 220, and 230 and the first, second, and third light source units 110, 120, and 230 of Figure 2, respectively.

The fourth light source unit 340 is arranged to face the third outer surface 435. Thus, a fourth light beam L₄₂ emitted from the fourth light source unit 340 is transmitted through the third outer surface 435 and propagates toward the fifth boundary surface 431.

In the embodiment of Figure 7, the colour separation portion includes first, second, and third dichroic filters 441, 445, and 447 provided between the second boundary surface 413 and the third boundary surface 421, the sixth boundary surface 433 and the first boundary surface 411, and the fourth boundary surface 423 and the fifth boundary surface 431 respectively.

The third dichroic filter 447 separates the third light beam L₃₂ and the fourth light beam L₄₂, by transmitting the third light beam L₃₂ and reflecting the fourth light beam L₄₂. For example, using a predetermined threshold between red and yellow wavebands, for example, 600 nm, when the third light beam L₃₂ is a light beam in a red wavelength range and the fourth light beam L₄₂ is a light beam in a yellow wavelength range, the third light beam L₃₂ is transmitted by the third dichroic filter 447 while the fourth light beam L₄₂ is reflected.

Since the first and second dichroic filters 441 and 445 perform substantially the same operations as the first and second dichroic filters 241 and 245 of Figure 2, detailed descriptions thereof are omitted. The second dichroic filter 445 transmits the first and second light beams L₁₂ and L₂₂ and reflects the third and fourth light beams L₃₂ and L₄₂ so that these light beams proceed along a common path.

The fourth light beam L₄₂ is not limited to a light beam having a yellow wavelength. Instead, the fourth light source unit 340 may be arranged to emit a light beam having another wavelength in order to widen a colour range of the illumination unit. For example, a fourth light source unit 340 arranged to emit a magenta or cyan light beam may be used. In addition, although the first, second, third, and fourth light beams L₁₂, L₂₂, L₃₂, and L₄₂ are described above as having green, blue, red, and yellow wavelengths, the invention is not limited to illumination units using based on these four colours. One or more of these colours may be replaced with others, by providing a suitable light source unit and first, second and third dichroic filters.

In the illumination unit of Figure 7, by combining the light beams emitted by the first , second, third, and fourth light source units 310, 320, 330, and 340 using the prism arrangement 400, the optical path can be easily changed and the optical arrangement is relatively easy when compared to a conventional trichroic prism. Also, since an image is realised by the combination of four colours, the range of colours that can be presented is increased.

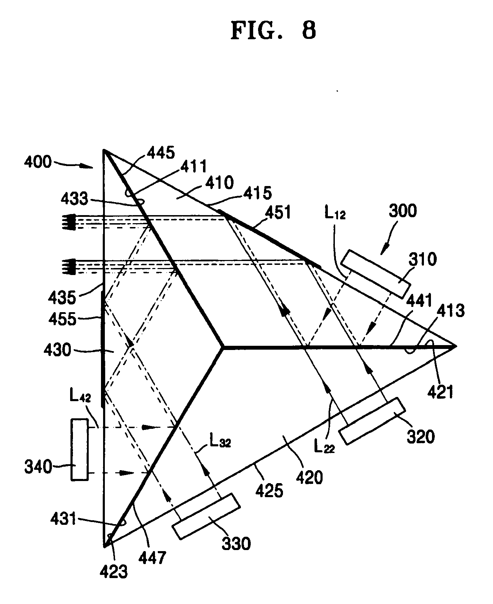

Figure 8 is a view of an optical arrangement of an illumination unit according to a second embodiment of the invention. Referring to Figure 8, the illumination unit includes a plurality of the light source units 300 arranged to emit light beams having different wavelengths and a prism arrangement 400 configured to combine incident light beams so that each of the light beams emitted from the light source unit 300 proceeds along a common path.

The illumination unit of Figure 8 is similar to the illumination unit of Figure 7, as it includes first and second reflection layers 451 and 455 to enhance the reflection properties at the first and third outer surfaces 415 and 435. Since the configuration and arrangement of the other constituent elements are substantially the same as those of the illumination unit of Figure 7, detailed descriptions thereof are omitted.

The first reflection layer 451 is formed by coating a portion of the first outer surface 415 with reflective material to totally reflect the first and second light beams L₁₂ and L₂₂ passing through the first dichroic filter 441. Since the first reflection layer 451 does not extend to a portion of the first outer surface 415 where the first light beam L₁₂ emitted from the first light source unit 310 enters the prism arrangement 400, the first reflection layer 451 does not impede the propagation of the first light beam L₁₂ toward the first dichroic filter 441.

The second reflection layer 455 is formed by coating a portion of the third outer surface 435 with a reflective material so as to reflect the third and fourth light beams L₃₂ and L₄₂ passing through the third dichroic filter 447. Since the second reflection layer 455 does not obstruct the optical path along which the first, second, third, and fourth light beams L₁₂, L₂₂, L₃₂, and L₄₂ pass through when leaving the second dichroic filter 445, it does not impede the propagation of the first, second, third, and fourth light beams L₁₂, L₂₂, L₃₂, and L₄₂ along the common path.

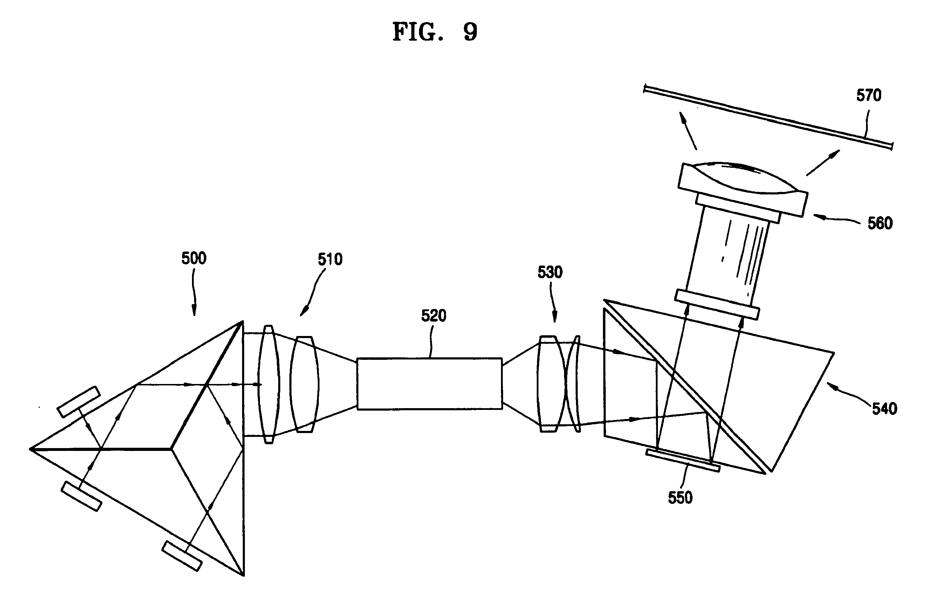

Figure 9 is a view illustrating an optical arrangement of an image projecting apparatus outside the scope of the present invention. The image projecting apparatus includes an illumination unit 500, an image forming device 550 to form an image corresponding to an image signal of a light beam emitted from the illumination unit 500, and a projection lens unit 560 to magnify and project the image formed by the image forming device 550 onto a screen 570.

The illumination unit 500 includes a plurality of light source units arranged at different positions and a prism arrangement configured to combine a plurality of light beams emitted from the light source units.

Although the illumination unit depicted in Figure 9 is that shown in Figure 2, in an image projecting apparatus according to an embodiment of the invention, the configuration of the illumination unit is, instead, substantially the same as one of the illumination units shown in Figures 7 and 8.

Continuing with the example shown in Figure 9, the light source units of the illumination unit 500, which are driven to be turned on and off in sequence, emit three or more colour light beams sequentially, such as light beams having green, blue, and red wavelengths or light beams having green, blue, red, and yellow (or magenta or cyan) wavelengths. Thus, in an image projecting apparatus comprising a single panel-type image forming device, the illumination unit 500 avoids the need for a colour wheel mechanism when generating a colour image.

The image forming device 550 forms an image by driving pixel units to selectively reflect incident uniform illumination. The image forming device 550 may be a reflection type liquid crystal display (LCD) device, a transmission type LCD device, or a digital micromirror device (DMD). While the reflection type LCD device and the transmission type LCD device generate an image using polarisation properties of an incident light beam, the DMD does not use the polarisation property. Thus, where the DMD is used as the image forming device 550, an additional polarisation conversion device or a polariser is not required.

In the example illustrated in Figure 9, a DMD is used as the image forming device 550. The DMD includes a two-dimensional micromirror array, in which the micromirrors can be driven independently of one another. The DMD forms an image by setting an angle of reflection of incident light for each pixel according to an input image signal. In this example, a beam splitter 540 is provided between the image forming device 550 and the projection lens unit 560. The beam splitter 540 changes the path of an incident light beam such that a light beam emitted by the illumination unit 500 proceeds toward the image forming device 550 and a light beam coming from the image forming device 550 proceeds toward the screen 570. The beam splitter 540 is a critical angle prism which changes the path of a light beam using total internal reflection.

The projection lens unit 560, which is arranged to face the beam splitter 540, magnifies an image formed by the image forming device 550 and passing through the beam splitter 540 and projects the magnified image toward the screen 570.

The image projecting apparatus of Figure 9 further includes an optical integrator 520, arranged between the illumination unit 500 and the beam splitter 540, to make the light beam emitted by the illumination unit 500 parallel. The optical integrator 520 may be a glass rod having a cubic shape, along which the light beam travels while undergoing total internal reflection. In this case, a condensing lens unit 510 is further provided between the light source unit 500 and the optical integrator 520. The condensing lens unit 510 comprises at least one lens unit to concentrate the beam emerging from the prism arrangement 500 onto the glass rod.

The image projecting apparatus further includes a relay lens unit 530 positioned between the optical integrator 520 and the beam splitter 540. The relay lens unit 530 comprises at least one lens to relay the uniform light beam output from the glass rod to the image forming device 550.

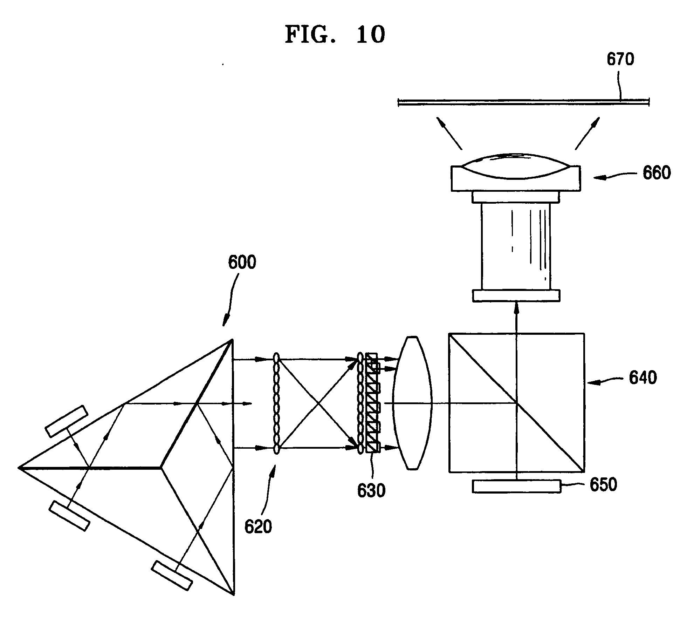

Figure 10 depicts an optical arrangement of an image projecting apparatus outside the scope of the invention the invention. Referring to Figure 10, the image projecting apparatus includes an illumination unit 600, an image forming device 650 arranged to form an image corresponding to an image signal and a projection lens unit 660 to magnify and project the image formed by the image forming device 650 onto a screen 670. In an image projecting apparatus according to another embodiment of the invention, the illumination unit shown in Figure 7 or 8 is used in place of the illumination unit 600 shown in Figure 10.

The image forming device 650 forms an image by driving its pixels to selectively reflect incident light. In the apparatus of Figure 10, a reflection type LCD device is used as an image forming device 650 and generates an image by selectively altering the polarisation properties of an incident light beam.

In this case, the projecting apparatus further includes a polarisation beam splitter 640 arranged between the illumination unit 600, the image forming device 650, and the projection lens unit 660. The polarisation beam splitter 640 changes the path of the incident light beam so that a light beam coming from the illumination unit 600 proceeds toward the image forming device 650 and a light beam coming from the image forming device 650 proceeds toward the screen 670. To this end, a polarisation changing device 630 is provided between the illumination unit 600 and the polarisation beam splitter 640 and arranged to change a polarisation direction of an incident light beam to enable a light beam having a particular polarisation to proceed towards the polarisation beam splitter 640. The polarisation changing device 630 includes a plurality of compact polarisation beam splitters and a quarter-wave plate and changes an unpolarised incident light beam to a light beam predominantly having a particular polarisation. Since the configuration of such polarisation changing devices 630 is well known, a detailed description thereof is omitted.

The image projecting apparatus further includes an optical integrator 620 to make the light beam emitted from the illumination unit 600 into a uniform light beam.

The optical integrator 620 is formed of a fly-eye lens array including at least one fly-eye lens that includes a plurality of lens cells having a convex or cylindrical shape and arranged to neighbour one another.

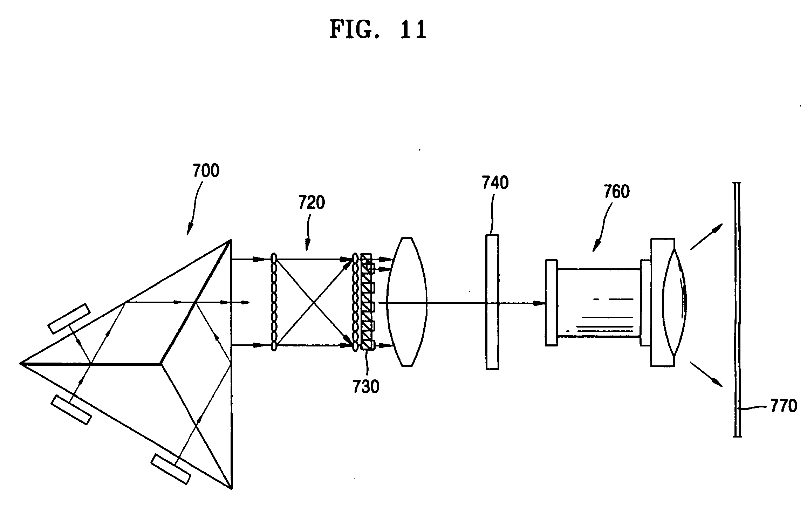

Figure 11 is a view illustrating an optical arrangement of yet another image projecting apparatus outside the scope of the invention. Referring to Figure 11, the image projecting apparatus includes an illumination unit 700, an image forming device 740 and a projection lens unit 760 to magnify and project an image formed by the image forming device 740 onto a screen 770. While Figure 11 depicts an image projecting apparatus in which the illumination unit 700 is outside the scope of the invention, in an image projecting apparatus according to yet another embodiment of the invention, the illumination unit of Figure 7 or 8 by provided in place of the illumination unit 700.

The image forming device 740 forms an image by driving its pixels to selectively reflect incident light. In this particular example, a transmission type LCD device is used as the image forming device 740. The transmission type LCD devise is configured to generate an image using the polarisation properties of an incident light beam. In this particular example, a unit to change a path of the incident light beam is not needed. Thus, the apparatus does not require a beam splitter.

Since the transmission type LCD device forms an image using polarisation properties, a polarisation changing device 730 is provided between the illumination unit 700 and the image forming device 740. The image projecting apparatus further includes an optical integrator 720 to make the light beam emitted from the illumination unit 700 uniform. The optical integrator 720 is formed of a fly-eye lens array including at least one fly-eye lens unit that includes a plurality of lens cells having a convex or cylindrical shape, arranged to neighbour one another.

In the illumination units described above, since light beams emitted from first, second, and third light source units are combined by using a prism arrangement 200, 400 having a triangular prism structure, the paths of the light beams can be easily changed using total internal reflection and the optical arrangement is straightforward when compared with a conventional trichroic prism structure. Also, since a light beam is collimated by using a reflection surface instead of a lens, the problem of low efficiency due to a principle limitation, such as etendue, is avoided. As an additional light source unit to emit a fourth light beam is provided, an increased range of colour can be obtained light beams of a variety of colours can be generated

Furthermore, since the image projecting apparatuses described above include such illumination units, the structure thereof can be made compact. Also, since a colour light beam is generated by using the light source units to emit light beams of different wavelengths, a colour image can be formed without using a colour wheel mechanism.

Although a few embodiments of the present general inventive concept have been shown and described, it will be appreciated by those skilled in the art that changes may be made in these embodiments without departing from the principles of the general inventive concept, the scope of which is defined in the appended claims.

## Claims

1. An illumination unit comprising:
a plurality of light source units (300) comprising first, second, third and fourth light source units (310, 320, 330, 340) arranged to emit light (L₁₂, L₂₂, L₃₂, L₄₂) in first, second third and fourth wavelength ranges respectively, said first, second, third and fourth wavelength ranges being different from one another; and
a synthesizing prism (400) arranged to combine the light (L₁₂, L₂₂) L₃₂, L₄₂) emitted from the light source units (300), comprising:
a first triangular prism (410) comprising a first outer surface (415) configured to transmit or reflect light according to a direction from which the light is incident, and first and second boundary surfaces (411, 413);
a second triangular prism (420) comprising a second outer surface (425) configured to transmit light, a third boundary surface (421) arranged to face the second boundary surface (421), and a fourth boundary surface (423);
a third triangular prism (430) comprising a third outer surface (435) configured to transmit or reflect light according to a direction from which the light is incident, a fifth boundary surface (431) arranged to face the fourth boundary surface (423), and a sixth boundary surface (433);
a first dichroic filter (441) arranged between the second boundary surface (413) and the third boundary surface (421) to reflect light in the first wavelength range and to transmit the light in the second wavelength range;
a second dichroic filter (445) configured to reflect the light in the third wavelength range and to transmit light in the second wavelength range; and
a third dichroic filter (447) arranged between the fourth boundary surface (423) and the fifth boundary surface (431), configured to reflect light in the fourth wavelength range and to transmit light in the third wavelength range;
**characterised by**:
the sixth boundary surface (433) being arranged to face the first boundary surface (411); and
the second dichroic filter (445) being arranged between the sixth boundary surface (433) and the first boundary surface (411) and configured to reflect light in the fourth wavelength range and to transmit light in the first wavelength range.

2. The illumination unit as claimed in claim 1, wherein the first, second and third triangular prisms (410, 420, 430) are of the same shape and size.

3. The illumination unit as claimed in claim 1, wherein the first, second and third triangular prisms (410, 420, 430) are arranged to form an equilateral triangle.

4. The illumination unit as claimed in claim 2, wherein the first, second and third triangular prisms (410, 420, 430) are congruent isosceles triangles arranged to form an equilateral triangle.

5. The illumination unit as claimed in any preceding claim, wherein each of the plurality of light source units (300) comprises at least one optical module (140) arranged to emit a parallel beam and including a collimator (150) having a reflection surface (151) and a light source (160) to emit light having in a corresponding one of the wavelength ranges disposed at a surface opposite to the reflection surface (151).

6. The illumination unit as claimed in claim 5, wherein the light source (160) is formed of one or more LED light sources or laser diodes forming an array.

7. The illumination unit as claimed in any preceding claim, wherein:
the first light source unit (310) is arranged to face the first outer surface (415) to emit light (L₁₂) toward the first dichroic filter (441);
the second light source unit (320) is arranged to face the second outer surface (425) to emit light (L₂₂) toward the first dichroic filter (441);
the third light source unit (330) is arranged to face the second outer surface (425) to emit light (L₃₂) toward the third dichroic filter (447); and
the fourth light source unit (340) is arranged to face the third outer surface (435) to emit light (L₄₂) toward the third dichroic filter (447).

8. The illumination unit as claimed in claim 7, wherein the first and second light source units (310, 320) are arranged such that light (L₁₂, L₂₂) from the first and second light source units (310, 320), incident via the first dichroic filter (441), is totally reflected by the first outer surface (415) and passes through the second dichroic filter (445) toward the third outer surface (435); and
the third and fourth light source units (330, 340) are arranged such that light (L_{32'} L₄₂) from the third and fourth light source units (330, 340), incident via the second dichroic filter (445), is totally reflected by the third outer surface (435) and proceeds toward the second dichroic filter (445).

9. The illumination unit as claimed in claim 7 or 8, wherein each of the first outer surface (415) and the third outer surface (435) comprises a portion (451) total reflection-coated to reflect light (L₁₂, L₂₂) from the first and second light source units (310, 320), incident via the first dichroic filter (441), and to transmit light (L₃₂, L₄₂) from the third and fourth light source units (330, 340), incident via the second dichroic filter (445), respectively.

10. The illumination unit as claimed in any preceding claim, wherein the light (L₁₂, L₂₂, L₃₂) emitted by the first, second and third light source units (310, 320, 330) comprises:
red light;
green light; and
blue light.

11. The illumination unit as claimed in any of claims 1 to 10, wherein the light emitted from the plurality of light source units (300) comprises at least one of:
yellow light;
cyan light; and
magenta light.

12. A display apparatus comprising:
an imaging device (550, 650, 740); and
an illumination unit according to any of claims 1 to 11, arranged to illuminate said imaging device (550, 650, 740).

13. A display apparatus according to claim 12, comprising:
a projection lens unit (560, 660, 760) to magnify an image formed by the imaging device (550, 650, 740) and to project the magnified image; and
a screen (570, 670, 770) to display the projected image.

14. A display apparatus according to claim 12 or 13, comprising an optical integrator (520, 620, 720) arranged between the illumination unit and the imaging device (550, 650, 740) to make the light emitted from the illumination unit uniform.

15. A display apparatus according to claim 14, wherein the optical integrator (520) comprises a glass rod having a cubic shape arranged so that light emitted from the illumination unit travels along the rod while undergoing total internal reflection.

16. A display apparatus according to claim 14, wherein the optical integrator (620, 720) comprises a fly-eye lens array including at least one fly-eye lens including each of a plurality of lens cells having a convex or cylindrical shape arranged to neighbour one another.

17. A display apparatus according to claim 14, 15 or 16, wherein the imaging device (550, 650) comprises a reflection type image forming device configured to form the image by selectively reflecting the uniform light output by the optical integrator (520, 620), and further comprising:
a beam splitter (540, 640) arranged between the illumination unit and the imaging device (550, 650) to change a path of the uniform light and the image such that the uniform light output by the optical integrator (520, 620) proceeds toward the imaging device (550, 650) and the image formed by the imaging device (550, 650) proceeds toward the projection lens unit (560, 660).

18. A display apparatus according to claim 17, wherein the imaging device (550) comprises a digital micromirror device and the beam splitter (540) comprises an internal total reflection mirror arranged to totally reflect the uniform light output by the optical integrator (520) toward the digital micromirror device and to transmit the image formed by the digital micromirror device toward the projection lens unit (560).

19. A display apparatus according to claim 17 or 18, comprising:
a polarization changing device (630) arranged between the illumination unit and the beam splitter (640) arranged to make the uniform light proceeding towards the beam splitter (640) have a particular polarization, wherein the imaging device (650) comprises a reflection-type LCD device, and the beam splitter (640) comprises a polarization beam splitter to transmit or reflect the uniform light and the image according to a polarization direction thereof.

20. A display apparatus according to claim 14, comprising:
a polarization changing device (730) arranged between the illumination unit and the imaging device (740) arranged to make the uniform light proceeding towards the beam splitter have a particular polarization, wherein the imaging device (740) comprises a transmission-type LCD device arranged to form the image by selectively transmitting the uniform light emitted from the optical integrator (720).

## Patentansprüche

1. Beleuchtungseinheit, enthaltend:
eine Vielzahl von Lichtquelleneinheiten (300), die eine erste, eine zweite, eine dritte und eine vierte Lichtquelleneinheit (310, 320, 330, 340) enthalten, die so angeordnet sind, dass sie Licht (L₁₂, L₂₂, L₃₂, L₄₂) in einem ersten, einem zweiten, einem dritten bzw. einem vierten Wellenlängenbereich emittieren, wobei sich der erste, der zweite, der dritte und der vierte Wellenlängenbereich voneinander unterscheiden; und
ein Synthetisierprisma (400), das so eingerichtet ist, dass es das Licht (L₁₂, L₂₂, L₃₂, L₄₂) kombiniert, das von den Lichtquelleneinheiten (300) abgestrahlt wird, enthaltend:
ein erstes dreieckiges Prisma (410), das eine erste Außenfläche (415), die so beschaffen ist, dass sie Licht gemäß einer Richtung, aus der das Licht einfällt, durchlässt oder reflektiert, und eine erste sowie eine zweite Grenzfläche (411, 413) enthält;
ein zweites dreieckiges Prisma (420), das eine zweite Außenfläche (425), die so beschaffen ist, dass sie Licht durchlässt, eine dritte Grenzfläche (421), die so angeordnet ist, dass sie der zweiten Grenzfläche (421) zugewandt ist, und eine vierte Grenzfläche (423) enthält;
ein drittes dreieckiges Prisma (430), das eine dritte Außenfläche (435), die so beschaffen ist, dass sie Licht gemäß einer Richtung, aus der das Licht einfällt durchlässt oder reflektiert, eine fünfte Grenzfläche (431), die so angeordnet ist, dass sie der vierten Grenzfläche (423) zugewandt ist, und eine sechste Grenzfläche (433) enthält;
ein erstes dichriotisches Filter (441), das zwischen der zweiten Grenzfläche (413) und der dritten Grenzfläche (421) angeordnet ist, um Licht im ersten Wellenlängenbereich zu reflektieren und Licht im zweiten Wellenlängenbereich durchzulassen;
ein zweites dichriotisches Filter (445), das so beschaffen ist, dass es das Licht im dritten Wellenlängenbereich reflektiert und Licht im zweiten Wellenlängenbereich durchlässt; und
ein drittes dichriotisches Filter (447), das zwischen der vierten Grenzfläche (423) und der fünften Grenzfläche (431) angeordnet und so beschaffen ist, dass es Licht im vierten Wellenlängenbereich reflektiert und Licht im dritten Wellenlängenbereich durchlässt;
**dadurch gekennzeichnet, dass**:
die sechste Grenzfläche (433) so angeordnet ist, dass sie der ersten Grenzfläche (411) zugewandt ist; und
das zweite dichriotische Filter (445) zwischen der sechsten Grenzfläche (433) und der ersten Grenzfläche (411) angeordnet und so beschaffen ist, dass es Licht im vierten Wellenlängenbereich reflektiert und Licht im ersten Wellenlängenbereich durchlässt.

2. Beleuchtungseinheit nach Anspruch 1, bei der das erste, das zweite und das dritte dreieckige Prisma (410, 420, 430) dieselbe Form und Größe haben.

3. Beleuchtungseinheit nach Anspruch 1, bei der das erste, das zweite und das dritte dreieckige Prisma (410, 420, 430) so angeordnet sind, dass sie ein gleichseitiges Dreieck bilden.

4. Beleuchtungseinheit nach Anspruch 2, bei der das erste, das zweite und das dritte dreieckige Prisma (410, 420, 430) kongruente, gleichschenkelige Dreiecke sind, die so angeordnet sind, dass sie ein gleichseitiges Dreieck bilden.

5. Beleuchtungseinheit nach einem der vorhergehenden Ansprüche, bei der jede aus der Vielzahl von Lichtquelleneinheiten (300) wenigstens ein optisches Modul (140) enthält, das so angeordnet ist, dass es einen parallelen Strahl emittiert, und einen Kollimator (150) enthält, der eine Reflexionsfläche (151) und eine Lichtquelle (160), um Licht in einem der entsprechenden Wellenlängenbereiche zu emittieren, die an einer Oberfläche gegenüberliegend der Reflexionsfläche (151) angeordnet ist, aufweist.

6. Beleuchtungseinheit nach Anspruch 5, bei der die Lichtquelle (160) aus einer oder mehreren LED-Lichtquellen oder Laserdioden besteht, die eine Anordnung bilden.

7. Beleuchtungseinheit nach einem der vorhergehenden Ansprüche, bei der:
die erste Lichtquelleneinheit (310) so angeordnet ist, dass sie der ersten Außenfläche (415) zugewandt ist, um Licht (L₁₂) zum ersten dichriotischen Filter (441) zu emittieren;
die zweite Lichtquelleneinheit (320) so angeordnet ist, dass sie der zweiten Außenfläche (425) zugewandt ist, um Licht (L₂₂) zum ersten dichriotischen Filter (441) zu reflektieren;
die dritte Lichtquelleneinheit (330) so angeordnet ist, dass sie der zweiten Außenfläche (425) zugewandt ist, um Licht (L₃₂) zum dritten dichriotischen Filter (447) zu reflektieren; und
die vierte Lichtquelleneinheit (340) so angeordnet ist, dass sie der dritten Außenfläche (435) zugewandt ist, um Licht (L₄₂) zum dritten dichriotischen Filter (447) zu reflektieren.

8. Beleuchtungseinheit nach Anspruch 7, bei der die erste und die zweite Lichtquelleneinheit (310, 320) so angeordnet sind, dass Licht (L₁₂, L₂₂) von der ersten und der zweiten Lichtquelleneinheit (310, 320), das über das erste dichriotische Filter (441) einfällt, vollständig von der ersten Außenfläche (415) reflektiert wird und das zweite dichriotische Filter (445) zur dritten Außenfläche (435) durchläuft; und
die dritte und vierte Lichtquelleneinheit (330, 340) so angeordnet sind, dass Licht (L₃₂, L₄₂) von der dritten und der vierten Lichtquelleneinheit (330, 340), das über das zweite dichriotische Filter einfällt, vollständig von der dritten Außenfläche (435) reflektiert wird und sich zum zweiten dichriotischen Filter (445) ausbreitet.

9. Beleuchtungseinheit nach Anspruch 7 oder 8, bei der jeweils die erste Außenfläche (415) und die dritte Außenfläche (435) einen Abschnitt (451) aufweisen, der totalreflexionsbeschichtet ist, um Licht (L₁₂, L₂₂) von der ersten und der zweiten Lichtquelleneinheit (310, 320), das über das erste dichriotische Filter (441) einfällt, zu reflektieren bzw. Licht (L₃₂, L₄₂) von der dritten und der vierten Lichtquelleneinheit (330, 340), das über das zweite dichriotische Filter (445) einfällt, durchzulassen.

10. Beleuchtungseinheit nach einem der vorhergehenden Ansprüche, bei dem das Licht (L₁₂, L₂₂, L₃₂), das von der ersten, der zweiten und der dritten Lichtquelleneinheit (310, 320, 330) reflektiert wird,
rotes Licht;
grünes Licht und
blaues Licht enthält.

11. Beleuchtungseinheit nach einem der Ansprüche 1 bis 10, bei der das Licht, das von der Vielzahl der Lichtquelleneinheiten (300) emittiert wird,
gelbes Licht;
zyanfarbiges Licht und/oder
magentafarbiges Licht enthält.

12. Anzeigevorrichtung, enthaltend:
eine Abbildungsvorrichtung (550, 650, 740); und
eine Beleuchtungseinheit gemäß einem der Ansprüche 1 bis 11, die so angeordnet ist, dass sie die Abbildungsvorrichtung (550, 650, 740) beleuchtet.

13. Anzeigevorrichtung nach Anspruch 12, enthaltend:
eine Projektionslinseneinheit (560, 660, 760), um eine Abbildung zu vergrößern, die von der Abbildungsvorrichtung (550, 650, 740) ausgebildet wird, und die vergrößerte Abbildung zu projizieren; und
einen Bildschirm (570, 670, 770), um die projizierte Abbildung anzuzeigen.

14. Anzeigevorrichtung nach Anspruch 12 oder 13, enthaltend eine optische Integrationseinrichtung (520, 620, 720), die zwischen der Beleuchtungseinheit und der Abbildungsvorrichtung (550, 650, 740) angeordnet ist, um das Licht, das von der Beleuchtungseinheit emittiert wird, einheitlich zu machen.

15. Anzeigevorrichtung nach Anspruch 14, bei der die optische Integrationseinrichtung (520) einen Glasstab enthält, der eine kubische Form hat und so angeordnet ist, dass sich Licht, das von der Beleuchtungseinheit emittiert wird, entlang des Stabes ausbreitet, während es einer inneren Totalreflexion unterzogen wird.

16. Anzeigevorrichtung nach Anspruch 14, bei der die optische Integrationseinrichtung (620, 720) eine Facettenlinsenanordnung enthält, die wenigstens eine Facettenlinse enthält, die jeweils eine aus einer Vielzahl von Linsenzellen enthält, die eine konvexe oder zylindrische Form haben und zueinander benachbart angeordnet sind.

17. Anzeigevorrichtung nach Anspruch 14, 15 oder 16, bei der die Abbildungsvorrichtung (550, 650) eine Abbildungsausbildungsvorrichtung vom Reflexionstyp enthält, die so beschaffen ist, dass sie die Abbildung **dadurch** ausbildet, dass sie das einheitliche Licht, das von der optischen Integrationseinrichtung (520, 560) ausgegeben wird, selektiv reflektiert, und weiterhin enthält:
einen Strahlteiler (540, 640), der zwischen der Beleuchtungseinheit und der Abbildungsvorrichtung (550, 650) angeordnet ist, um einen Weg des einheitlichen Lichtes und der Abbildung derart zu ändern, dass sich das einheitliche Licht, das von der optischen Integrationseinrichtung (520, 620) ausgegeben wird, zur Abbildungsvorrichtung (550, 650) ausbreitet und sich die Abbildung, die von der Abbildungsvorrichtung (550, 650) ausgebildet wird, zur Projektionslinseneinheit (560, 660) ausbreitet.

18. Anzeigevorrichtung nach Anspruch 17, bei der die Abbildungsvorrichtung (550) eine digitale Mikrospiegelvorrichtung enthält und der Strahlteiler (540) einen inneren Totalreflexionsspiegel enthält, der so angeordnet ist, dass er das ren Totalreflexionsspiegel enthält, der so angeordnet ist, dass er das einheitliche Licht, das von der optischen Integrationseinrichtung (520) ausgegeben wird, zur digitalen Mikrospiegelvorrichtung vollständig reflektiert und die Abbildung, die von der digitalen Mikrospiegelvorrichtung ausgebildet wird, zur Projektionslinseneinheit (560) überträgt.

19. Anzeigevorrichtung nach Anspruch 17 oder 18, enthaltend:
eine Polarisationsänderungsvorrichtung (630), die zwischen der Beleuchtungseinheit und dem Strahlteiler (640) angeordnet und so eingerichtet ist, dass sie dem einheitlichen Licht, das sich zum Strahlteiler (640) ausbreitet, eine spezielle Polarisation verleiht, wobei die Abbildungsvorrichtung (650) eine LCD-Vorrichtung vom Reflexionstyp enthält und der Strahlteiler (640) einen Polarisationsstrahlteiler enthält, der das einheitliche Licht und die Abbildung gemäß einer Polarisationsrichtung derselben überträgt oder reflektiert.

20. Anzeigevorrichtung nach Anspruch 14, enthaltend:
eine Polarisationsänderungsvorrichtung (730), die zwischen der Beleuchtungseinheit und der Abbildungsvorrichtung (740) angeordnet und so eingerichtet ist, dass sie dem einheitlichen Licht, das sich zum Strahlteiler ausbreitet, eine spezielle Polarisation verleiht, wobei die Abbildungsvorrichtung (740) eine LCD-Vorrichtung vom Übertragungstyp enthält, die so angeordnet ist, dass sie die Abbildung durch selektives Übertragen des einheitlichen Lichtes ausbildet, das von der optischen Integrationseinrichtung (720) emittiert wird.

## Revendications

1. Unité d'éclairage comprenant :
une pluralité d'unités de source de lumière (300) comprenant des première, deuxième, troisième et quatrième unités de source de lumière (310, 320, 330, 340) agencées pour émettre une lumière (L₁₂, L₂₂, L₃₂, L₄₂) dans des première, deuxième, troisième et quatrième plages de longueur d'onde, respectivement, lesdites première, deuxième, troisième et quatrième plages de longueur d'onde étant différentes les unes des autres ; et
un prisme de synthèse (400) agencé pour combiner les lumières (L₁₂, L₂₂, L₃₂, L₄₂) émises par les unités de source de lumière (300), comprenant :
un premier prisme triangulaire (410) comprenant une première surface extérieure (415) configurée pour transmettre ou réfléchir la lumière en fonction d'une direction d'incidence de la lumière, et des première et deuxième surfaces de frontière (411, 413) ;
un deuxième prisme triangulaire (420) comprenant une deuxième surface extérieure (425) configurée pour transmettre la lumière, une troisième surface de frontière (421) agencée de manière à faire face à la deuxième surface de frontière (421), et une quatrième surface de frontière (423) ;
un troisième prisme triangulaire (430) comprenant une troisième surface extérieure (435) configurée pour transmettre ou réfléchir la lumière en fonction d'une direction d'incidence de la lumière, une cinquième surface de frontière (431) agencée de manière à faire face à la quatrième surface de frontière (423), et une sixième surface de frontière (433) ;
un premier filtre dichroïque (441) agencé entre la deuxième surface de frontière (413) et la troisième surface de frontière (421) pour réfléchir la lumière dans la première plage de longueur d'onde et pour transmettre la lumière dans la deuxième plage de longueur d'onde ;
un deuxième filtre dichroïque (445) configuré pour réfléchir la lumière dans la troisième plage de longueur d'onde et pour transmettre la lumière dans la deuxième plage de longueur d'onde ; et
un troisième filtre dichroïque (447) agencé entre la quatrième surface de frontière (423) et la cinquième surface de frontière (431), configuré pour réfléchir la lumière dans la quatrième plage de longueur d'onde et pour transmettre la lumière dans la troisième plage de longueur d'onde ;
**caractérisée en ce que** :
la sixième surface de frontière (433) est agencée de manière à faire face à la première surface de frontière (411) ; et
le deuxième filtre dichroïque (445) est agencé entre la sixième surface de frontière (433) et la première surface de frontière (411) et est configuré pour réfléchir la lumière dans la quatrième plage de longueur d'onde et pour transmettre la lumière dans la première plage de longueur d'onde.

2. Unité d'éclairage selon la revendication 1, dans laquelle les premier, deuxième et troisième prismes triangulaires (410, 420, 430) ont la même forme et la même taille.

3. Unité d'éclairage selon la revendication 1, dans laquelle les premier, deuxième et troisième prismes triangulaires (410, 420, 430) sont agencés pour former un triangle équilatéral.

4. Unité d'éclairage selon la revendication 2, dans laquelle les premier, deuxième et troisième prismes triangulaires (410, 420, 430) sont des triangles isocèles congruents agencés pour former un triangle équilatéral.

5. Unité d'éclairage selon l'une quelconque des revendications précédentes, dans laquelle chacune de la pluralité d'unités de source de lumière (300) comprend au moins un module optique (140) agencé pour émettre un faisceau parallèle et comprenant un collimateur (150) comportant une surface de réflexion (151) et une source de lumière (160) pour émettre une lumière dans l'une correspondante des plages de longueur d'onde disposée au niveau d'une surface opposée à la surface de réflexion (151).

6. Unité d'éclairage selon la revendication 5, dans laquelle la source de lumière (160) est constituée d'une ou de plusieurs sources de lumière à DEL ou diodes laser formant un réseau.

7. Unité d'éclairage selon l'une quelconque des revendications précédentes, dans laquelle :
la première unité de source de lumière (310) est agencée de manière à faire face à la première surface extérieure (415) pour émettre une lumière (L₁₂) vers le premier filtre dichroïque (441) ;
la deuxième unité de source de lumière (320) est agencée de manière à faire face à la deuxième surface extérieure (425) pour émettre une lumière (L₂₂) vers le premier filtre dichroïque (441) ;
la troisième unité de source de lumière (330) est agencée de manière à faire face à la deuxième surface extérieure (425) pour émettre une lumière (L₃₂) vers le troisième filtre dichroïque (447) ; et
la quatrième unité de source de lumière (340) est agencée de manière à faire face à la troisième surface extérieure (435) pour émettre une lumière (L₄₂) vers le troisième filtre dichroïque (447).

8. Unité d'éclairage selon la revendication 7, dans laquelle les première et deuxième unités de source de lumière (310, 320) sont agencées de sorte que les lumières (L₁₂, L₂₂) provenant des première et deuxième unités de source de lumière (310, 320), arrivant par l'intermédiaire du premier filtre dichroïque (441), soient totalement réfléchies par la première surface extérieure (415) et traversent le deuxième filtre dichroïque (445) vers la troisième surface extérieure (435) ; et
les troisième et quatrième unités de source de lumière (330, 340) sont agencées de sorte que les lumières (L₃₂, L₄₂) provenant des troisième et quatrième unités de source de lumière (330, 340), arrivant par l'intermédiaire du deuxième filtre dichroïque (445), soient totalement réfléchies par la troisième surface extérieure (435) et se propagent vers le deuxième filtre dichroïque (445).

9. Unité d'éclairage selon la revendication 7 ou 8, dans laquelle chacune de la première surface extérieure (415) et de la troisième surface extérieure (435) comprend une partie (451) revêtue pour une réflexion totale pour réfléchir les lumières (L₁₂, L₂₂) provenant des première et deuxième unités de source de lumière (310, 320), arrivant par l'intermédiaire du premier filtre dichroïque (441), et pour transmettre les lumières (L₃₂, L₄₂) provenant des troisième et quatrième unités de source de lumière (330, 340), arrivant par l'intermédiaire du deuxième filtre dichroïque (445), respectivement.

10. Unité d'éclairage selon l'une quelconque des revendications précédentes, dans laquelle les lumières (L₁₂, L₂₂, L₃₂) émises par les première, deuxième et troisième unités de source de lumière (310, 320, 330) comprennent :
une lumière rouge ;
une lumière verte ; et
une lumière bleue.

11. Unité d'éclairage selon l'une quelconque des revendications 1 à 10, dans laquelle les lumières émises par la pluralité d'unités de source de lumière (300) comprennent au moins l'une d'une :
lumière jaune :
lumière cyan ; et
lumière magenta.

12. Dispositif d'affichage comprenant :
un dispositif de formation d'image (550, 650, 740) ; et
une unité d'éclairage selon l'une quelconque des revendications 1 à 11, agencée pour éclairer ledit dispositif de formation d'image (550, 650, 740).

13. Dispositif d'affichage selon la revendication 12, comprenant :
une unité de lentille de projection (560, 660, 760) pour agrandir une image formée par le dispositif de formation d'image (550, 650, 740) et pour projeter l'image agrandie ; et
un écran (570, 670, 770) pour afficher l'image projetée.

14. Dispositif d'affichage selon la revendication 12 ou 13, comprenant un intégrateur optique (520, 620, 720) agencé entre l'unité d'éclairage et le dispositif de formation d'image (550, 650, 740) pour rendre la lumière émise par l'unité d'éclairage uniforme.

15. Dispositif d'affichage selon la revendication 14, dans lequel l'intégrateur optique (520) comprend une tige en verre ayant une forme cubique agencée de sorte que la lumière émise par l'unité d'éclairage se propage le long de la tige tout en subissant une réflexion interne totale.

16. Dispositif d'affichage selon la revendication 14, dans lequel l'intégrateur optique (620, 720) comprend un réseau de lentilles oeil de mouche comprenant au moins une lentille oeil de mouche comprenant chacune une pluralité de cellules de lentille ayant une forme convexe ou cylindrique agencées de manière à être voisines les unes des autres.

17. Dispositif d'affichage selon la revendication 14, 15 ou 16, dans lequel le dispositif de formation d'image (550, 650) comprend un dispositif de formation d'image du type à réflexion configuré pour former l'image en réfléchissant de manière sélective la lumière uniforme délivrée par l'intégrateur optique (520, 620), et comprenant en outre :
un diviseur de faisceau (540, 640) agencé entre l'unité d'éclairage et le dispositif de formation d'image (550, 650) pour modifier un trajet de la lumière uniforme et de l'image de sorte que la lumière uniforme délivrée par l'intégrateur optique (520, 620) se propage vers le dispositif de formation d'image (550, 650) et que l'image formée par le dispositif de formation d'image (550, 650) se propage vers l'unité de lentille de projection (560, 660).

18. Dispositif d'affichage selon la revendication 17, dans lequel le dispositif de formation d'image (550) comprend un dispositif à micro-miroir numérique et le diviseur de faisceau (540) comprend un miroir à réflexion totale interne agencé pour réfléchir totalement la lumière uniforme délivrée par l'intégrateur optique (520) vers le dispositif à micro-miroir numérique et pour transmettre l'image formée par le dispositif à micro-miroir numérique vers l'unité de lentille de projection (560).

19. Dispositif d'affichage selon la revendication 17 ou 18, comprenant :
un dispositif de modification de polarisation (630) agencé entre l'unité d'éclairage et le diviseur de faisceau (640) agencé pour faire en sorte que la lumière uniforme se propageant vers le diviseur de faisceau (640) ait une polarisation particulière, dans lequel le dispositif de formation d'image (650) comprend un dispositif à cristaux liquides de type à réflexion, et le diviseur de faisceau (640) comprend un diviseur de faisceau par polarisation pour transmettre ou réfléchir la lumière uniforme et l'image en fonction d'une direction de polarisation de celles-ci.

20. Dispositif d'affichage selon la revendication 14, comprenant :
un dispositif de modification de polarisation (730) agencé entre l'unité d'éclairage et le dispositif de formation d'image (740) agencé pour faire en sorte que la lumière uniforme se propageant vers le diviseur de faisceau ait une polarisation particulière, dans lequel le dispositif de formation d'image (740) comprend un dispositif à cristaux liquides de type à transmission agencé pour former l'image en transmettant de manière sélective la lumière uniforme émise par l'intégrateur optique (720).
